# EUROPÄISCHE PATENTSCHRIFT

(11) **EP 3 212 725 B1**
(45) Veröffentlichungstag und Bekanntmachung des Hinweises auf die Patenterteilung: **06.03.2024**
(21) Anmeldenummer: 15781109.2
(22) Anmeldetag: 15.10.2015
(51) Int. Cl.: C09J 11/06, C09J 9/00, C09J 7/10, C09J 153/00, C08F 287/00, C08G 59/24, C08G 59/68, C08L 91/00, C09D 163/00, H10K 50/842

(54) **OLED KOMPATIBLE KLEBEMASSEN MIT SILANWASSERFÄNGERN**
OLED-COMPATIBLE ADHESIVE MASSES HAVING SILANE WATER SCAVENGERS
MATIÈRES ADHÉSIVES OLED-COMPATIBLES COMPORTANT DES AGENTS DE CAPTATION D'EAU SILANÉE

(30) Priorität: 29.10.2014 DE 102014222027
(43) Veröffentlichungstag der Anmeldung: 06.09.2017
(73) Patentinhaber: tesa SE, 22848 Norderstedt (DE)
(72) Erfinder: KEITE-TELGENBÜSCHER, Klaus, 22529 Hamburg (DE); SCHUH, Christian, 22767 Hamburg (DE)
(74) Vertreter: tesa SE
(86) Internationale Anmeldenummer: PCT/EP2015/073896
(87) Internationale Veröffentlichungsnummer: WO 2016/066434

(56) Entgegenhaltungen:
- WO-A1-2015/154947
- US-A1- 2008 063 871
- US-A1- 2010 137 530
- DATABASE WPI Week 201442 Thomson Scientific, London, GB; AN 2014-L83161 XP002753055, -& CN 103 756 579 A (CHANGZHOU SIWEIKE PHOTOVOLTAIC NEW) 30. April 2014 (2014-04-30)

## Beschreibung

Die vorliegende Erfindung betrifft eine Barriereklebemasse für die Kapselung einer (opto-)elektronischen Anordnung, gemäß Anspruch 1 enthaltend eine Klebstoffbasis aus mindestens einem Reaktivharz mit mindestens einer aktivierbaren Gruppe, mindestens einem Elastomer, optional mindestens einem Klebharz, wobei die Klebstoffbasis eine Wasserdampfpermeationsrate nach der Aktivierung von weniger als 100 g/m²d, bevorzugt von weniger als 50 g/m²d, insbesondere weniger als 15 g/m²d aufweist, ein transparentes molekular dispergiertes Gettermaterial sowie optional ein Lösungsmittel. Des Weiteren betrifft die Erfindung ein Klebeband mit dieser Klebemasse sowie die Verwendung einer solchen Klebemasse. (Opto-)elektronische Anordnungen werden immer häufiger in kommerziellen Produkten verwendet. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren wie Hochdruck, Tiefdruck, Siebdruck, Flachdruck oder wie auch so genanntes "non impact printing" wie etwa Thermotransferdruck Tintenstrahldruck oder Digitaldruck. Vielfach werden aber auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet, wobei die Strukturierung in der Regel durch Masken erfolgt.

Als Beispiele für bereits kommerzielle oder in ihrem Marktpotential interessante (opto-)elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenz-lampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen, Perowskitsolarzellen, organische Feldeffekt-Transistoren, organische Schaltelemente, organische optische Verstärker, organische Laserdioden, organische oder anorganische Sensoren oder auch organisch- oder anorganischbasierte RFID-Transponder angeführt.

Weitere Anwendungen verkapselnder Klebebänder sind im Bereich der Batterietechnik bekannt, insbesondere im Bereich der flexiblen Mikrobatterien und Dünnschichtbatterien, ganz besonders solchen umfassend lithiumhaltige Kathoden, Anoden oder Elektrolyte.

Demgemäß wird in dieser Schrift unter einer organischen (opto-)elektronischen Anordnung eine elektronische Anordnung verstanden, die zumindest einen elektronisch funktionalen, zumindest teilweise organischen Bestandteil umfasst - zum Beispiel metallorganische Verbindungen - oder deren elektronisch funktionaler Aufbau eine Dicke von weniger als 20 µm aufweist.

Als technische Herausforderung für die Realisierung ausreichender Lebensdauer und Funktion von (opto-)elektronischen Anordnungen im Bereich der anorganischen und/oder organischen (Opto-)Elektronik, ganz besonders aber im Bereich der organischen (Opto-)Elektronik ist ein Schutz der darin enthaltenen Komponenten vor Permeaten zu sehen. Permeaten können eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasser oder Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So können sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Um eine möglichst gute Versiegelung zu erzielen, werden spezielle Barriereklebemassen (auch als wasserdampfsperrende Klebemassen bezeichnet) verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeaten unter stationären Bedingungen bei bestimmter Permeationsweglänge, Partialdruck und Temperatur. Die Permeabilität P ist das Produkt aus Diffusions-Term D und Löslichkeits-Term S: P = D * S.

Der Löslichkeitsterm S beschreibt vorwiegend die Affinität der Barriereklebemasse zum Permeaten. Im Fall von Wasserdampf wird beispielsweise ein geringer Wert für S von hydrophoben Materialen erreicht. Der Diffusionsterm D ist ein Maß für die Beweglichkeit des Permeaten im Barrierematerial und ist direkt abhängig von Eigenschaften wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent, und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere berücksichtigen im Hinblick auf den Einfluss auf die Durchlässigkeit von Wasserdampf und Sauerstoff. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Ein geringer Löslichkeits-Term S allein ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeits-Term), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Beschrieben sind Barriereklebemassen auf der Basis von Styrolblockcopolymeren und möglichst hydrierten Harzen (siehe DE 10 2008 047 964 A1).

Hier werden auch Permeationswerte (WVTR) von weit verbreiteten Klebstoffsystemen angegeben (gemessen bei 37.5°C und 90% relativer Feuchte). Typische Haftklebemassen auf Acrylatbasis liegen im Bereich zwischen 100 g/m² d und 1000 g/m² d. Silikonhaftklebemassen haben aufgrund der hohen Beweglichkeit der Ketten noch höhere Permeationswerte für Wasser von über 1000 g/m² d. Werden Styrolblockcopolymere als Elastomerkomponente verwendet, so werden für nicht oder nicht-vollständig hydrierteSysteme WVTR-Werte im Bereich von 50 - 100 g/m² d und für hydrierte Systeme (zum Beispiel SEBS) Werte unter 50 g/m² d erreicht. Besonders niedrige WVTR-Werte von unter 15 g/m² d werden sowohl mit reinen Poly(isobutylen)elastomeren oder Blockcopolymeren aus Styrol und Isobutylen erreicht.

Die CN 103 756 579 A offenbart einen EVA-Klebstoff umfassend Ethylvinylacetatcopolymer, Vernetzer, Antioxidanz, UV-Absorbenz, Lichtstabilisator, Silanvernetzer und Wassersperrmittel, welcher als Heißklebstoff appliziert wird.

In der US 2008/063871 A1 werden epoxidhaltige Haftklebmassen beschrieben, die hohe Verklebungsfestigkeiten ergeben, wobei die WVTR-Werte der darin offenbarten Beispiele deutlich über 100g/m²d liegen.

Die US 2010/137530 A1 offenbart eine spezielle Mischung verschiedener Epoxidharze, die bei 25°C fest ist und erst ab ca. 50°C erweicht, wobei es sich um einen Schmelzklebstoff mit einem WVTR-Wert von größer als 100 g/m²d handelt.

Eine Möglichkeit, die Barrierewirkung noch zu verbessern, ist der Einsatz von Stoffen, die mit Wasser oder Sauerstoff reagieren. In die (opto-)elektronische Anordnung eindringender Sauerstoff oder Wasserdampf wird dann an diese Stoffe chemisch oder physikalisch, bevorzugt chemisch gebunden und erhöhen somit die Durchbruchszeit ("lag-time"). Diese Stoffe werden in der Literatur als "Getter", "scavenger", "desiccants" oder "absorber" bezeichnet. Im Folgenden wird nur der Ausdruck Getter verwendet. Die Bindung des eindringenden Wassers erfolgt entweder physikalisch durch Adsorption typischerweise an Silica, Molekularsieben, Zeoliten oder Natriumsulfat. Chemisch wird Wasser über Alkoxysilane, Oxazolidine, Isocyanate, Bariumoxid, Phosphorpentoxid, Alkali- und Erdalkalioxide (wie beispielsweise Calciumoxid), metallisches Calcium oder Metallhydride gebunden (WO 2004/009720 A2). Zur transparenten Verklebung zum Beispiel von Displays eignen sich einige Füllstoffe allerdings nicht, da die Transparenz der Klebmasse reduziert wird.

Beschrieben als solche Getter sind in Klebmassen hauptsächlich anorganische Füllstoffe wie beispielsweise Calciumchlorid oder verschiedene Oxide (vergleiche US 5,304,419 A, EP 2 380 930 A1 oder US 6,936,131 A). Solche Klebemassen dominieren bei der Randverkapselung, das heißt in Fällen, in denen nur Ränder zu verkleben sind. Für eine vollflächige Verkapselung sind Klebmassen mit solchen Gettern jedoch ungeeignet, da sie, wie oben ausgeführt, die Transparenz reduzieren.

Auch organische Getter sind in Klebemassen beschrieben. So zum Beispiel in der EP 2 597 697 A1, in der polymere Alkoxysilane als Getter verwendet werden. Zahlreiche verschiedene Silane als Getter in Klebemassen werden in der WO 2014/001005 A1 genannt. Gemäß dieser Schrift beträgt die Höchstmenge an einzusetzendem Getter 2 Gew.-%, da bei Verwendung von höheren Gettermengen der empfindliche zu verkapselnde elektronische Aufbau geschädigt würde. Problematisch ist, dass die eingesetzten organischen Gettermaterialien zumeist sehr reaktiv sind und bei Kontakt mit der empfindlichen organischen Elektronik bei der vollflächigen Verkapselung zu Schäden (sogenannte "dark spots") führen. Auch Klebmassen mit solchen Gettern sind somit nur für die Randverkapselung geeignet, wo eine Beeinträchtigung der Transparenz keine Rolle spielt.

Gettermaterialien sind zusammenfassend beispielsweise Salze wie Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Kieselsäuren (zum Beispiel Silica Gel), Aluminiumsulfat, Calciumsulfat, Kupfersulfat, Bariumsulfat, Magnesiumsulfat, Lithiumsulfat, Natriumsulfat, Cobaltsulfat, Titansulfat, Natriumdithionit, Natriumcarbonat, Kaliumdisulfit, Kaliumcarbonat, Magnesiumcarbonat, Titandioxid, Kieselgur, Zeolithe, Schichtsilikate wie Montmorillonit und Bentonit, Metalloxide wie Bariumoxid, Calciumoxid, Eisenoxid, Magnesiumoxid, Natriumoxid, Kaliumoxid,Strontiumoxid, Aluminiumoxid (aktiviertes Alumina); weiter Kohlenstoffnanoröhrchen, Aktivkohle, Phosphorpentoxid und Silane; leicht oxidierbare Metalle wie beispielsweise Eisen, Calcium, Natrium und Magnesium; Metallhydride wie beispielsweise Calciumhydrid, Bariumhydrid, Strontiumhydrid, Natriumhydrid und Lithiumaluminiumhydrid; Hydroxide wie Kaliumhydroxid und Natriumhydroxid, Metallkomplexe wie zum Beispiel Aluminiumacetylacetonat; des Weiteren organische Absorber, beispielsweise Polyolefin-Copolymere, Polyamid-Copolymere, PET-Copolyester, Anhydride von einfachen und mehrfachen Carbonsäuren wie Essigsäureanhydrid, Propionsäureanhydrid, Buttersäureanhydrid oder Methyltetrahydrophtalsäureanhydrid, Isocyanate oder weitere auf Hybridpolymeren basierte Absorber, die meist in Kombination mit Katalysatoren wie beispielsweise Cobalt verwendet werden; weitere organische Absorber wie etwa schwach vernetzte Polyacrylsäure, Polyvinylalkohol, Ascorbate, Glucose, Gallussäure oder ungesättigte Fette und Öle.

Die Gettermaterialien werden ihrer Funktion entsprechend bevorzugt als im Wesentlichen von Permeaten freie Materialien eingesetzt, zum Beispiel wasserfrei. Dies unterscheidet Gettermaterialien von ähnlichen Materialien, die als Füllstoff eingesetzt werden. So wird Silica zum Beispiel in der Form von pyrogener Kieselsäure häufig als Füllstoff eingesetzt. Wird dieser Füllstoff jedoch wie üblich unter Umgebungsbedingungen gelagert, nimmt er bereits Wasser aus der Umgebung auf und ist nicht mehr in technisch nutzbarem Umfang als Gettermaterial funktionsfähig. Erst getrocknetes oder trocken gehaltenes Silica kann als Gettermaterial genutzt werden. Es ist jedoch auch möglich, bereits teilweise mit Permeaten komplexierte Materialien zu verwenden, beispielsweise CaSO₄*1/2H₂O (Calciumsulfat-Halbhydrat) oder teilhydrierte Kieselsäuren, die per Definition als Verbindungen der allgemeinen Formel (SiO₂)m*nH₂O vorliegen.

Unter Kieselsäuren werden, wie vorstehend beschrieben, Verbindungen der allgemeinen Formel (SiO₂)m*nH₂O verstanden. Es handelt sich dabei um durch nasschemische, thermische oder pyrogene Verfahren hergestelltes Siliciumdioxid. Insbesondere sind unter den Kieselsäuren Kieselgele beziehungsweise Silicagele, beispielsweise mit Kobalt-Verbindungen als Feuchteindikator imprägnierte Kieselgele (Blaugel), und pyrogene Kieselsäuren geeignete Gettermaterialien.

Im Falle der vollflächigen Verkapselung stehen sich somit die entgegengesetzten Anforderungen einer hohen Reaktivität des Getters, um einen möglichst großen Schutz vor dem Eindringen von Wasserdampf zu gewährleisten, auf der einen Seite und einer geringen Reaktivität des Getters, um die empfindliche organische Elektronik nicht zu schädigen, auf der anderen Seite gegenüber.

Der Erfindung lag daher die Aufgabe zugrunde, eine Klebemasse zur Verfügung zu stellen, die eine hohe Durchbruchzeit (> 1100 h (60 °C / 90 % r.F. Lagerung) und > 220 h (85 °C / 85 % r.F. Lagerung) aufweist und die flächig zur Verkapselung von Aufbauten aus der organischen Elektronik eingesetzt werden kann, ohne die empfindliche organische Elektronik zu beschädigen

Überraschenderweise wurde gefunden, dass hohe Durchbruchszeiten erreicht werden können, ohne dass die organische Elektronik nennenswert geschädigt wird, und diese bei Erhalten einer großen Transparenz, wenn bei einer eingangs genannten Barriereklebemasse als das Gettermaterial mindestens ein Silan eingesetzt wird, das mindestens eine Alkoxygruppe und mindestens eine aktivierbare Gruppe aufweist, wobei das Reaktivharz und das Silan chemisch gleichartige aktivierbare Gruppen aufweisen,
die aktivierbare Gruppe mindestens eine Gruppe ausgewählt aus der Gruppe, umfassend cyclische Ethergruppen, insbesondere Epoxide und Oxetane, Acrylate und Methacrylate, ist, die Klebemasse haftklebrig ist und
das Elastomer mindestens ein Vinylaromatenblockcopolymer ist.

Überraschend wurde festgestellt, dass die im Vergleich zu dem Fachmann bekannten organischen Wasserfängern wie beispielsweise Oxazolidine, α-Silane oder Carbodiimide weniger reaktiven Alkoxysilane die Permeation von Feuchtigkeit durch die Klebemasse deutlich verringern und vollflächig auf Aufbauten der organischen Elektronik (zum Beispiel OLED) verklebt werden können, ohne diese zu schädigen.

Erfindungsgemäß geeignet sind Klebemassen, in denen Reaktivharz und Alkoxysilan mindestens eine chemisch gleichartige, insbesondere mindestens eine dieselbe aktivierbare Gruppe aufweisen. In diesem Fall können Reaktivharz und Alkoxysilan auf besonders gute Weise miteinander polymerisieren und vernetzen. Unter "gleichartigen funktionellen polymerisierbaren Gruppen" sind dabei solche zu verstehen, die einander chemisch sehr ähnlich sind ausgewählt aus der Gruppe umfassend cyclische Ether mit verschiedener Ringgröße, aliphatische Epoxide und cycloaliphatische Epoxide oder Acrylate und Methacrylate.

Besonders gute Aktivitäten erreicht man, wenn die Alkoxygruppe eine Ethoxygruppe ist. Es hat sich gezeigt, dass überraschenderweise die im Vergleich zu Methoxysilanen unreaktiveren Ethoxysilane vor allen Dingen bei hohen Temperaturen die Permeation von Feuchtigkeit deutlich besser reduzieren. Dies ist unerwartet, da Methoxysilane normalerweise eine höhere Reaktivität aufweisen als die entsprechenden Ethoxysilane (vergleiche Wacker Produktbeschreibung 6085e/09.13 "GENIOSL^{®}", Seite 11 aus September 2013 (09.13)).

Als aktivierbare Gruppe sind cyclische Ether, Acrylate oder Methacrylate geeignet. Als cyclische Ethergruppe sind dabei eine Epoxid- oder eine Oxetangruppe besonders geeignet, wobei die Silane 2-(3,4-Epoxycyclohexyl)ethylmethyldimethoxysilan, 2-(3,4-Epoxycyclohexyl)ethylmethyldiethoxysilan, gamma-(Glycidoxypropyl)trimethoxysilan, gamma-(Glycidoxypropyl)triethoxysilan sowie insbesondere 2-(3,4-Epoxycyclohexyl)ethyltrimethoxysilan und/oder 2-(3,4-Epoxycyclohexyl)ethyltriethoxysilan bevorzugt werden.

Besonders gute Eigenschaften weisen Klebemassen auf, bei denen die Menge an Gettermaterial mindestens 2 Gew.-%, vorzugsweise mindestens 3 Gew.-%, insbesondere mindestens 4 Gew.-% und ganz besonders bevorzugt mindestens 5 Gew.-% beträgt. Weiterhin ist vorteilhaft, wenn die Menge an Gettermaterial gleichzeitig oder alternativ höchstens 15 Gew.-% beträgt. Dabei sind die Bereiche 3 bis 15 Gew.-%, vorzugsweise 4 bis 10 Gew.-% und insbesondere 4,5 bis 7 Gew.-% ganz besonders bevorzugt. Eine größere Menge an Gettermaterial erhöht die Durchbruchszeit und ist daher wünschenswert. Auf der anderen Seite nimmt die Netzwerkdichte ab, wenn größere Mengen an Getter eingearbeitet werden, was der Getterwirkung aufgrund der erhöhten Permeation entgegenwirkt, so dass die Menge an Gettermaterial auch nach oben begrenzt ist.

Die erfindungsgemäße Klebemasse ist teilvernetzbar, da sie neben der mindestens einen Reaktivharzkomponente auch noch mindestens ein Elastomer und optional ein Klebharz enthält. Geeigneterweise liegt der Gelgehalt der Klebemasse, das heißt derjenige Anteil der Klebemasse, der sich bei Lösen der Klebemasse in einem geeigneten Lösungsmittel nicht lösen lässt, bei weniger als 90 Gew.-%, insbesondere bei weniger als 80 Gew.-%, vorzugsweise bei weniger als 70 Gew.-%, besonders bevorzugt bei weniger als 50 Gew.-% und ganz besonders bevorzugt bei weniger als 30 Gew.-%.

Der Anteil des Reaktivharzes in der Klebemasse beträgt gemäß einer vorteilhaften Ausführungsform 15 bis 80 Gew.-%, insbesondere 20 bis 70 Gew.-% und besonders bevorzugt 25 bis 65 Gew.-%. Um eine gute Handhabbarkeit und elastische Klebmasse nach Aushärtung zu erzielen, ist ein bevorzugter Reaktivharzanteil 15 bis 35 Gew.-%, insbesondere 20 bis 30 Gew.-%. Für stärker vernetzte Verklebungen sind Reaktivharzanteile von 65 bis 80 Gew.-% bevorzugt. Besonders ausgewogen in Bezug auf Elastizität und Vernetzungsgrad sind Reaktivharzanteile von 35 bis 65 Gew.-%.

In einer bevorzugten Ausführung enthält das Reaktivharz Epoxidgruppen, insbesondere aliphatische und ganz besonders bevorzugt cycloaliphatische Epoxidgruppen. Sehr gut geeignet sind Reaktivharze, die als aktivierbare Gruppe Glycidyl- und/oder Epoxycyclohexylgruppen enthalten.

Vorzugsweise ist das Alkoxysilan eine Verbindung der allgemeinen Formel 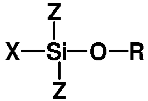 wobei
- R ein Alkyl- oder ein Arylrest ist, wobei Ethyl besonders bevorzugt ist,
- X ein Rest mit Glycidyl- oder Epoxycyclohexylgruppe, ein Acrylat oder ein Methacrylat ist und
- Z eine Alkyl- oder Arylgruppe oder eine Alkoxygruppe ist, wobei die Reste Z gleich oder verschieden sein können.

Der Rest Z kann eine beliebige Alkyl- oder Arylgruppe oder ein Alkoxygruppe sein, wobei eine Alkoxygruppe besonders bevorzugt ist. Ganz besonders gute Ergebnisse lassen sich erzielen, wenn auch Z eine Ethoxygruppe ist. Der Rest Z kann auch unterschiedlich sein. So kann das Alkoxysilan als Rest Z sowohl eine Ethoxy- wie auch eine Methoxygruppe enthalten.

In einer besonders bevorzugten Ausführung ist die Gruppe X des Getters 2-(3,4-Epoxycyclohexyl).

Erfindungsgemäß können auch Mischungen aus zwei oder mehreren Gettermaterialien eingesetzt werden.

In einer bevorzugten Ausführung wird die Klebemasse kationisch, thermisch oder strahleninduziert ausgehärtet. Weiterhin ist es bevorzugt, dass die Klebemasse zumindest eine Sorte eines Initiators, insbesondere eines Photoinitiators, für die kationische Härtung der vernetzbaren Komponenten enthält.

Vorzugsweise ist das mindestens eine Elastomer aufgebaut aus zumindest einem olefinischen Monomer und/oder aus zumindest einem Polyurethan. Das Elastomer ist erfindungsgemäß mindestens ein Vinylaromatenblockcopolymer.

Die Barriereklebemasse kann nur das eine Elastomer als Polymer enthalten oder aber auch eine Mischung von zwei oder mehr verschiedenen Polymeren, wobei erfindungsgemäß mindestens ein Vinylaromatenblockcopolymer als Elastomer enthalten ist. Dabei kann das Polymer insbesondere ein Elastomer oder ein Thermoplast sein.

Als Elastomere können prinzipiell alle im Bereich der Haftklebemassen üblichen Elastomere verwendet werden, wie sie zum Beispiel in dem "Handbook of Pressure Sensitive Adhesive Technology" von Donatas Satas (Satas & Associates, Warwick 1999), beschrieben sind.

Bevorzugt im Sinne der Anmeldung sind die verwendeten Elastomere chemisch aus zumindest einem olefinischen Monomer oder aus Polyurethan aufgebaut und sind zum Beispiel Elastomere auf der Basis von Polyurethanen, Naturkautschuken, Synthesekautschuken wie Butyl-, (Iso)Butyl-, Nitril- oder Butadienkautschuke, Styrolblockcopolymeren mit einem Elastomerblock aus ungesättigten oder teilweise oder vollständig hydrierten Polydienblöcken (Polybutadien, Polyisopren, Poly(iso)butylen, Copolymeren aus diesen sowie weitere, dem Fachmann geläufige Elastomerblöcke), Polyolefinen, Fluorpolymeren und/oder Silikonen.

Kommen Kautschuk oder Synthesekautschuk oder daraus erzeugte Verschnitte als Basismaterial für die Haftklebemasse zum Einsatz, dann kann der Naturkautschuk grundsätzlich aus allen erhältlichen Qualitäten wie zum Beispiel Crepe-, RSS-, ADS-, TSR- oder CV-Typen, je nach benötigtem Reinheits- und Viskositätsniveau, und der Synthesekautschuk oder die Synthesekautschuke aus der Gruppe der statistisch copolymerisierten Styrol-Butadien-Kautschuke (SBR), der Butadien-Kautschuke (BR), der synthetischen Polyisoprene (IR), der Butyl-Kautschuke (IIR), der halogenierten Butyl-Kautschuke (XIIR), der Acrylat-Kautschuke (ACM), der Ethylenvinylacetat-Copolymere (EVA) oder der Polyurethane und/oder deren Verschnitten gewählt werden.

Als Polymer kann auch jegliche dem Fachmann bekannte Art von Thermoplasten zum Einsatz kommen, wie sie zum Beispiel in den Lehrbüchern "Chemie und Physik der synthetischen Polymere" von J.M.G. Cowie (Vieweg, Braunschweig) und "Makromolekulare Chemie" von B. Tieke (VCH Weinheim, 1997) genannt sind. Dies sind zum Beispiel Poly(ethylen), Poly (propylen), Poly (vinylchlorid), Poly (styrol), Poly (oxymethylene), Poly (ethylenoxid), Poly (ethylenterephthalat), Poly (carbonate), Poly (phenylenoxide), Poly (urethane), Poly(harnstoffe), Phenoxy-Harze, Acrylnitril-Butadien-Styrol (ABS), Poly(amide) (PA), Poly (lactat) (PLA), Poly (etheretherketon) (PEEK), Poly (sulfon) (PSU), Poly (ethersulfon) (PES). Poly (acrylate), Poly (methacrylate) und Poly (methylmethacrylate) (PMMA) sind zwar als Polymer ebenfalls möglich, jedoch nicht bevorzugt im Sinne der vorliegenden Erfindung.

Als Reaktivharze, auch als vernetzbare Komponenten bezeichnet, können im Prinzip alle, dem Fachmann im Bereich der Haftklebemassen oder Reaktivklebstoffe bekannten, in einer Aufbaureaktion vernetzenden Makromoleküle bildenden reaktiven Konstituenten verwendet werden, wie sie zum Beispiel in Gerd Habenicht "Kleben - Grundlagen, Technologien, Anwendungen", 6. Auflage, Springer, 2009, beschrieben sind. Dies sind beispielhaft Konstituenten, die Epoxide, Polyester, Polyether, Polyurethane, Phenolharz, Kresol oder Novolak basierte Polymere, Polysulfide oder Acrylpolymere (Acryl, Methacryl) bilden.

Der Aufbau und die chemische Beschaffenheit der vernetzbaren Komponente sind nicht kritisch, solange sie mit der Elastomerphase zumindest teilweise mischbar sind und die Aufbaureaktion unter Bedingungen, insbesondere hinsichtlich der angewendeten Temperaturen, der Art der verwendeten Katalysatoren und dergleichen, durchgeführt werden kann, die zu keiner wesentlichen Beeinträchtigung und/oder Zersetzung der Elastomerphase führen.

Das Reaktivharz besteht bevorzugt aus einem cyclischen Ether und eignet sich für die strahlenchemische und gegebenenfalls thermische Vernetzung mit einer Erweichungstemperatur von kleiner 40 °C, bevorzugt von kleiner 20 °C.

Bei den Reaktivharzen auf Basis cyclischer Ether handelt es sich insbesondere um Epoxide, also Verbindungen, die zumindest eine Oxiran-Gruppe tragen, oder Oxetane. Sie können aromatischer oder insbesondere aliphatischer oder cycloaliphatischer Natur sein.

Einsetzbare Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandiglycidylether und Derivate, 1,3-Propandiglycidylether und Derivate, 1,4-Butandioldiglycidylether und Derivate, höhere 1,n-Alkandiglycidylether und Derivate, Bis-[(3,4-epoxycyclohexyl)methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidylether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks, 2-(7-Oxabicyclo;Spiro[1,3-dioxane-5,3'-[7]oxabicyclo[4.1.0]-heptane], 1,4-Bis((2,3-epoxypropoxy)methyl)cyclohexane.

Zur kationischen Härtung eignen sich besonders Reaktivharze auf Cyclohexylepoxid-Basis wie beispielsweise 3,4-Epoxycyclohexylmethyl-3`,4`-epoxycyclohexancarboxylat (EEC) und Derivate sowie Bis-[(3,4-epoxycyclohexyl)methyl]-adipat und Derivate.

Reaktivharze können in ihrer monomeren oder auch dimeren, trimeren, usw. bis hin zu ihrer oligomeren Form eingesetzt werden.

Gemische von Reaktivharzen untereinander, aber auch mit anderen coreaktiven Verbindungen wie Alkoholen (monofunktionell oder mehrfach funktionell) oder Vinylethern (monofunktionell oder mehrfach funktionell) sind ebenfalls möglich.

Unter den Initiatoren für eine kationische UV-Härtung sind insbesondere Sulfonium, lodonium und Metallocen basierende Systeme einsetzbar. Als Beispiele für Sulfonium basierende Kationen sei auf die Ausführungen in US 6,908,722 B1 (insbesondere Spalten 10 bis 21) verwiesen.

Als Beispiele für Anionen, die als Gegenionen für die oben genannten Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Tetrakispentafluorophenylborat, Tetrakis-(pentafluoromethylphenyl)-borat, Bi-(trifluoromethylsulfonyl)-amide und Tris-(trifluoromethylsulfonyl)-methide genannt. Ferner sind insbesondere für lodonium-basierende Initiatoren auch Chlorid, Bromid oder lodid als Anionen denkbar, wobei aber Initiatoren, die im Wesentlichen frei von Chlor und Brom sind, bevorzugt sind.

### Konkreter zählen zu den einsetzbaren Systemen

- Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat, Triphenylsulfoniumhexafluoroborat, Triphenylsulfoniumtetrafluoroborat, Triphenylsulfoniumtetrakis-(pentafluorobenzyl)-borat, Methyldiphenylsulfoniumtetrafluoroborat, Methyldiphenylsulfoniumtetrakis-(pentafluorobenzyl)-borat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, 4-Acetylphenyldiphenylsulfoniumtetrakis-(pentafluorobenzyl)-borat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(methoxynaphthyl)-methylsulfoniumetrakis-(pentafluorobenzyl)-borat, Di-(carbomethoxyphenyl)-methylsulfoniumhexafluorophosphat, (4-Octyloxyphenyl)-diphenylsulfoniumtetrakis-(3,5-bis-trifluoromethylphenyl)-borat, Tris-[4-(4-acetylphenyl)-thiophenyl]-sulfoniumtetrakis-(pentafluorophenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, 4-Acetamidphenyldiphenylsulfoniumtetrakis-(pentafluorobenzyl)-borat, Dimethylnaphthylsulfoniumhexafluorophosphat, Trifluoromethyldiphenylsulfoniumtetrafluoroborat, Trifluoromethyldiphenylsulfoniumtetrakis-(pentafluorobenzyl)-borat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 10-Phenyl-9-oxothioxantheniumtetrakis-(pentafluorobenzyl)-borat, 5-Methyl-10-oxothianthreniumtetrafluoroborat, 5-Methyl-10-oxothianthreniumtetrakis-(pentafluorobenzyl)-borat und 5-Methyl-10,10-dioxothianthreniumhexafluorophosphat,
- lodonium-Salze (siehe zum Beispiel US 3,729,313 A, US 3,741,769 A, US 4,250,053 A, US 4,394,403 A und US 2010/063221 A1) wie
   Diphenyliodoniumtetrafluoroborat,
   Di-(4-methylphenyl)-iodoniumtetrafluoroborat,
   Phenyl-4-methylphenyliodoniumtetrafluoroborat,
   Di-(4-chlorphenyl)-iodoniumhexafluorophosphat, Dinaphthyliodoniumtetrafluoroborat,
   Di-(4-trifluormethylphenyl)-iodoniumtetrafluoroborat, Diphenyliodoniumhexafluorophosphat,
   Di-(4-methylphenyl)-iodoniumhexafluorophosphat, Diphenyliodoniumhexafluoroarsenat,
   Di-(4-phenoxyphenyl)-iodoniumtetrafluoroborat,
   Phenyl-2-thienyliodoniumhexafluorophosphat,
   3,5-Dimethylpyrazolyl-4-phenyliodoniumhexafluorophosphat, Diphenyliodoniumhexafluoroantimonat,
   2,2'-Diphenyliodoniumtetrafluoroborat,
   Di-(2,4-dichlorphenyl)-iodoniumhexafluorophosphat,
   Di-(4-bromphenyl)-iodoniumhexafluorophosphat,
   Di-(4-methoxyphenyl)-iodoniumhexafluorophosphat,
   Di-(3-carboxyphenyl)-iodoniumhexafluorophosphat,
   Di-(3-methoxycarbonylphenyl)-iodoniumhexafluorophosphat,
   Di-(3-methoxysulfonylphenyl)-iodoniumhexafluorophosphat,
   Di-(4-acetamidophenyl)-iodoniumhexafluorophosphat,
   Di-(2-benzothienyl)-iodoniumhexafluorophosphat,
   Diaryliodoniumtristrifluormethylsulfonylmethid wie
   Diphenyliodoniumhexafluoroantimonat,
   Diaryliodoniumtetrakis-(pentafluorophenyl)-borat wie
   Diphenyliodoniumtetrakis-(pentafluorophenyl)-borat,,
   (4-n-Desiloxyphenyl)-phenyliodoniumhexafluoroantimonat,
   [4-(2-Hydroxy-n-tetradesiloxy)-phenyl]-phenyliodoniumhexafluoroantimonat,
   [4-(2-Hydroxy-n-tetradesiloxy)-phenyl]-phenyliodoniumtrifluorosulfonat,
   [4-(2-Hydroxy-n-tetradesiloxy)-phenyl]-phenyliodoniumhexafluorophosphat,
   [4-(2-Hydroxy-n-tetradesiloxy)-phenyl]-phenyliodoniumtetrakis-(pentafluorophenyl)-borat,
   Bis-(4-tert-butylphenyl)-iodoniumhexafluoroantimonat,
   Bis-(4-tert-butylphenyl)-iodoniumhexafluorophosphat,
   Bis-(4-tert-butylphenyl)-iodoniumtrifluorosulfonat,
   Bis-(4-tert-butylphenyl)-iodoniumtetrafluoroborat,
   Bis-(dodecylphenyl)-iodoniumhexafluoroantimonat,
   Bis-(dodecylphenyl)-iodoniumtetrafluoroborat,
   Bis-(dodecylphenyl)-iodoniumhexafluorophosphat,
   Bis-(dodecylphenyl)-iodoniumtrifluoromethylsulfonat,
   Di-(dodecylphenyl)-iodoniumhexafluoroantimonat,
   Di-(dodecylphenyl)-iodoniumtriflat,
   Diphenyliodoniumbisulfat,
   4,4'-Dichlorodiphenyliodoniumbisulfat, 4,4'-Dibromodiphenyliodoniumbisulfat,
   3,3'-Dinitrodiphenyliodoniumbisulfat, 4,4'-Dimethyldiphenyliodoniumbisulfat,
   4,4'-Bis-succinimidodiphenyliodoniumbisulfat, 3-Nitrodiphenyliodoniumbisulfat, 4,4'-Dimethoxydiphenyliodoniumbisulfat,
   Bis-(dodecylphenyl)-iodoniumtetrakis-(pentafluorophenyl)-borat,
   (4-Octyloxyphenyl)-phenyliodoniumtetrakis-(3,5-bis-trifluoromethylphenyl)-borat und (Tolylcumyl)-iodoniumtetrakis-(pentafluorophenyl)-borat,
      und
- Ferrocenium-Salze (siehe zum Beispiel EP 0 542 716 B1) wie η5-(2,4-cyclopentadien-1-yl)-[(1,2,3,4,5,6,9)-(1-methylethyl)-benzol]-eisen.

Beispiele für kommerzialisierte Photoinitiatoren sind Cyracure UVI-6990, Cyracure UVI-6992, Cyracure UVI-6974 und Cyracure UVI-6976 der Firma Union Carbide, Optomer SP-55, Optomer SP-150, Optomer SP-151, Optomer SP-170 und Optomer SP-172 der Firma Adeka, San-Aid SI-45L, San-Aid SI-60L, San-Aid SI-80L, San-Aid SI-100L, San-Aid SI-110L, San-Aid SI-150L und San-Aid SI-180L der Firma Sanshin Chemical, SarCat CD-1010, SarCat CD-1011 und SarCat CD-1012 der Firma Sartomer, Degacure K185 der Firma Degussa, Rhodorsil Photoinitiator 2074 der Firma Rhodia, CI-2481, CI-2624, Cl-2639, CI-2064, CI-2734, CI-2855, CI-2823 und CI-2758 der Firma Nippon Soda, Omnicat 320, Omnicat 430, Omnicat 432, Omnicat 440, Omnicat 445, Omnicat 550, Omnicat 550 BL und Omnicat 650 der Firma IGM Resins, Daicat II der Firma Daicel, UVAC 1591 der Firma Daicel-Cytec, FFC 509 der Firma 3M, BBI-102, BBI-103, BBI-105, BBI-106, BBI-109, BBI-110, BBI-201, BBI, 301, BI-105, DPI-105, DPI-106, DPI-109, DPI-201, DTS-102, DTS-103, DTS-105, NDS-103, NDS-105, NDS-155, NDS-159, NDS-165, TPS-102, TPS-103, TPS-105, TPS-106, TPS-109, TPS-1000, MDS-103, MDS-105, MDS-109, MDS-205, MPI-103,, MPI-105, MPI-106, MPI-109, DS-100, DS-101, MBZ-101, MBZ-201, MBZ-301, NAI-100, NAI-101, NAI-105, NAI-106, NAI-109, NAI-1002, NAI-1003, NAI-1004, NB-101, NB-201, NDI-101, NDI-105, NDI-106, NDI-109, PAI-01, PAI-101, PAI-106, PAI-1001, PI-105, PI-106, PI-109, PYR-100, SI-101, SI-105, SI-106 und SI-109 der Firma Midori Kagaku, Kayacure PCI-204, Kayacure PCI-205, Kayacure PCI-615, Kayacure PCI-625, Kayarad 220 und Kayarad 620, PCI-061T, PCI-062T, PCI-020T, PCI-022T der Firma Nippon Kayaku, TS-01 und TS-91 der Firma Sanwa Chemical, Deuteron UV 1240 der Firma Deuteron, Tego Photocompound 1465N der Firma Evonik, UV 9380 C-D1 der Firma GE Bayer Silicones, FX 512 der Firma Cytec, Silicolease UV Cata 211 der Firma Bluestar Silicones und Irgacure 250, Irgacure 261, Irgacure 270, Irgacure PAG 103, Irgacure PAG 121, Irgacure PAG 203, Irgacure PAG 290, Irgacure CGI 725, Irgacure CGI 1380, Irgacure CGI 1907 und Irgacure GSID 26-1 der Firma BASF.

Dem Fachmann sind weitere Systeme bekannt, die ebenfalls erfindungsgemäß einsetzbar sind. Photoinitiatoren werden unkombiniert oder als Kombination von zwei oder mehreren Photoinitiatoren eingesetzt.

Geeignet als optional enthaltene Klebharze sind Klebharze, wie sie dem Fachmann zum Beispiel aus dem Satas bekannt sind.

Besonders vorteilhaft enthält die Haftklebemasse zumindest eine Sorte eines vorzugsweise zumindest teilhydrierten Klebharzes, vorteilhaft solche, die mit der Elastomerkomponente beziehungsweise, sofern ein aus Hart- und Weichblöcken aufgebautes Copolymer eingesetzt wird, hauptsächlich mit dem Weichblock verträglich sind (Weichharze).

Es ist vorteilhaft, wenn entsprechendes Klebharz eine Erweichungstemperatur gemessen mittels Ring & Ball-Methode von größer 25 °C aufweist. Es ist darüber hinaus vorteilhaft, wenn ergänzend zumindest eine Sorte Klebharz mit einer Erweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Für eher unpolare Elastomere können als Harze in der Haftklebemasse vorteilhaft partiell oder vollständig hydrierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von C₅-, C₅/C₉- oder C₉-Monomerströmen, Polyterpenharze auf Basis von α-Pinen und/oder β-Pinen und/oder δ-Limonen und/oder Δ³-Caren, hydrierte Polymerisate von bevorzugt reinen C₈- und C₉-Aromaten eingesetzt werden. Vorgenannte Klebharze können sowohl allein als auch im Gemisch eingesetzt werden.

Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, vorzugsweise von mindestens 95 % bevorzugt.

Der Klebemasse können übliche Zuschlagstoffe wie Alterungsschutzmittel (Antiozonantien, Antioxidantien, Lichtschutzmittel usw.) zugesetzt sein.

Als weitere Additive können typischerweise genutzt werden:
- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel sowie
- Endblockverstärkerharze.

Weiter bevorzugt kommt eine Klebemasse zum Einsatz, die in bestimmten Ausführungen im sichtbaren Licht des Spektrums (Wellenlängenbereich von etwa 400 nm bis 800 nm) transparent ist. "Transparenz" bedeutet dabei eine mittlere Transmission der Klebemasse im sichtbaren Bereich des Lichts von mindestens 75 %, bevorzugt höher als 90 %, wobei sich diese Betrachtung auf unkorrigierte Transmission, also ohne Grenzflächenreflexionsverluste herauszurechnen, bezieht.

Vorzugsweise zeigt die Klebemasse einen Haze kleiner 5,0 %, bevorzugt kleiner 2,5 %.

Die erfindungsgemäße Klebemasse ist haftklebrig. Dies ermöglicht eine besonders gute Handhabbarkeit, da die Klebemasse auch vor der Vernetzung bereits an der zu verklebenden Stelle haftet.

Als Haftklebemassen werden Klebemassen bezeichnet, die bereits unter relativ schwachem Andruck eine dauerhafte Verbindung mit dem Haftgrund erlauben und nach Gebrauch im Wesentlichen rückstandsfrei vom Haftgrund wieder abgelöst werden können. Haftklebemassen wirken bei Raumtemperatur permanent haftklebrig, weisen also eine hinreichend geringe Viskosität und eine hohe Anfassklebrigkeit auf, so dass sie die Oberfläche des jeweiligen Klebegrunds bereits bei geringem Andruck benetzen. Die Verklebbarkeit entsprechender Klebemassen beruht auf ihren adhäsiven Eigenschaften und die Wiederablösbarkeit auf ihren kohäsiven Eigenschaften. Als Basis für Haftklebemassen kommen verschiedene Materialien in Frage.

Die vorliegende Erfindung betrifft darüber hinaus ein Klebeband, das auf einer Seite oder auf beiden Seiten mit der erfindungsgemäßen Klebemasse beschichtet ist. Dabei kann es sich bei dem Klebeband auch um ein Transferklebeband handeln. Ein Klebeband ermöglicht eine besonders einfache und präzise Verklebung und ist daher besonders geeignet.

Schließlich betrifft die vorliegende Erfindung die Verwendung der erfindungsgemäßen Klebemasse beziehungsweise des erfindungsgemäßen Klebebandes als Dichtmasse, insbesondere zur Verkapselung von Aufbauten in der organischen Elektronik. Wie oben ausgeführt, ist es in der organischen Elektronik von eminenter Bedeutung, die Komponenten vor Wasser(dampf) geschützt werden müssen. Aufgrund ihrer sehr guten Barriereeigenschaften sind die erfindungsgemäßen Klebemassen beziehungsweise Klebebänder in der Lage, einen entsprechenden Schutz zu gewähren. Aufgrund der hohen Transparenz und der geringen Schädigung der zu verkapselnden Elektronik sind die erfindungsgemäße Klebemasse und das erfindungsgemäße Klebeband neben einer Randverkapselung insbesondere auch für eine vollflächige Verkapselung von organischer Elektronik geeignet.

Der allgemeine Ausdruck "Klebeband" umfasst ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-) elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-)elektronischen Anordnungen verwendet werden.

Es sind aber auch Klebebänder möglich, bei denen nicht mit zwei Linern sondern mit einem einzigen doppelseitig trennend ausgerüstet Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt, wobei Folien, insbesondere dimensionsstabile Kunststoff- oder Metallfolien, bevorzugt werden. Derartige Folien/Folienverbunde können aus allen gängigen zur Folienherstellung verwendeten Kunststoffen bestehen, beispielhaft aber nicht einschränkend erwähnt seien:
Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Polyesterfolien weisen den Vorteil auf, dass sie für Temperaturstabilität sorgen und eine erhöhte mechanische Stabilität einbringen. Ganz besonders bevorzugt besteht daher eine Trägerschicht in einem erfindungsgemäßen Liner aus einer Polyesterfolie, beispielsweise aus biaxial verstrecktem Polyethylenterephthalat.

In einer bevorzugten Ausführungsform enthält das Trägermaterial auch eine Barrierefunktion gegen ein oder mehrere spezifische(s) Permeat(e), insbesondere gegen Wasserdampf und Sauerstoff. Eine derartige Barrierefunktion kann aus organischen oder anorganischen Materialien bestehen. Trägermaterialien mit Barrierefunktion sind in EP 2 078 608 A1 ausführlich dargestellt.

Besonders bevorzugt enthält das Trägermaterial mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.

In einer Variante ist in dem doppelseitig (selbst)klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Die Dicke der Haftklebemasse, die entweder als Transferklebeband oder auf einem flächigen Gebilde beschichtet vorliegt, beträgt bevorzugt zwischen 1 µm und 2000 µm, weiter bevorzugt zwischen 5 µm und 500 µm und besonders bevorzugt zwischen etwa 12 µm und 250 µm.

Schichtdicken zwischen 50 µm und 150 µm werden dann eingesetzt, wenn eine verbesserte Haftung auf dem Substrat und/oder eine dämpfende Wirkung erreicht werden soll.

Schichtdicken zwischen 1 µm und 50 µm reduzieren den Materialeinsatz. Jedoch kommt es zu einer Verringerung der Haftung auf dem Substrat.

Für doppelseitige Klebebänder gilt für die Klebemasse(n) ebenfalls, dass die Dicke der einzelnen Haftklebemasseschicht(en) bevorzugt 1 µm und 2000 µm, weiter bevorzugt zwischen 5 µm und 500 µm und besonders bevorzugt zwischen etwa 12 µm und 250 µm liegt. Kommt in doppelseitigen Klebebändern neben der einen erfindungsgemäßen Klebemasse eine weitere zum Einsatz, dann kann es auch vorteilhaft sein, wenn ihre Dicke oberhalb 150 µm liegt.

Klebebänder, die ein- oder beidseitig mit Klebstoffen beschichtet sind, werden am Ende des Herstellungsprozesses zumeist zu einer Rolle in Form einer archimedischen Spirale aufgewickelt. Um bei doppelseitig klebenden Klebebändern zu verhindern, dass die Klebemassen miteinander in Kontakt kommen, oder um bei einseitig klebenden Klebebändern eine Verklebung der Klebemasse auf dem Träger zu verhindern, werden die Klebebänder vor dem Wickeln mit einem Abdeckmaterial (auch als Trennmaterial bezeichnet) eingedeckt, das zusammen mit dem Klebeband aufgewickelt wird. Dem Fachmann sind derartige Abdeckmaterialien unter den Namen Liner oder Releaseliner bekannt. Neben der Abdeckung von ein- oder doppelseitig klebenden Klebebändern werden Liner auch zur Eindeckung von reinen Klebemassen (Transferklebeband) und Klebebandabschnitten (zum Beispiel Etiketten) eingesetzt.

Ein weiterer Hauptanspruch betrifft ein Verfahren zum Schutz einer auf einem Substrat angeordneten organischen elektronischen Anordnung, wobei eine Abdeckung derart auf die elektronische Anordnung aufgebracht wird, dass die elektronische Anordnung zumindest teilweise durch die Abdeckung überdeckt wird, wobei weiterhin die Abdeckung zumindest teilflächig auf dem Substrat und/oder auf der elektronischen Anordnung verklebt wird, wobei die Verklebung mittels zumindest einer Schicht einer erfindungsgemäßen Barriereklebemasse bewirkt wird. Die Klebemassenschicht liegt dabei insbesondere als Schicht eines Klebebandes vor.

Das erfindungsgemäße Verfahren kann vorteilhaft derart geführt werden, dass zunächst die Schicht der erfindungsgemäßen Barriereklebemasse, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird. In einer weiteren vorteilhaften Vorgehensweise werden die Schicht der erfindungsgemäßen Barriereklebemasse, gegebenenfalls als Bestandteil eines weitere Schichten umfassenden doppelseitig klebenden Klebebandes, und die Abdeckung gemeinsam auf das Substrat und/oder die elektronische Anordnung aufgebracht.

Beim erfindungsgemäßen Verfahren kann das Transferklebeband somit zunächst mit dem Substrat beziehungsweise der elektronischen Anordnung verbunden werden oder zuerst mit der Abdeckung. Bevorzugt ist jedoch, zunächst das Transferklebeband mit der Abdeckung zu verbinden, da somit eine Baugruppe der elektronischen Funktionseinheit unabhängig von der elektronischen Anordnung vorgefertigt und als Ganzes zulaminiert werden kann.

Vorteilhaft kann das erfindungsgemäße Verfahren derart geführt werden, dass die Abdeckung und/oder die (Haft-)Klebstoffschicht, insbesondere als Transferklebeband, die elektronische Anordnung vollständig überdecken, da dann die lichtstreuende Wirkung die gesamte Fläche der Anordnung betrifft.

Durch die vollflächige Lamination des Transferklebebands über die elektronische Anordnung wird zudem die Einwirkung möglicherweise im Gasraum einer lediglich randverkapselten Anordnung eingeschlossener schädlicher Permeate ausgeschlossen, da es keinen Gasraum gibt.

Das erfindungsgemäße Verfahren wird bevorzugt derart geführt, dass auch ein Bereich des Substrats um die elektronische Anordnung herum durch die Abdeckung ganz oder teilweise überdeckt wird, wobei das Klebeband zur Verklebung die elektronische Anordnung dabei vollflächig bedecken kann und bevorzugt ebenfalls einen Bereich des Substrats um die elektronische Anordnung herum bedeckt, bevorzugt denselben Bereich wie die Abdeckung - oder teilflächig aufgebracht sein kann, etwa rahmenförmig um die elektronische Anordnung herum - bevorzugt in dem Bereich, der auch durch die Abdeckung bedeckt wird -, und gegebenenfalls zusätzlich in einem Randbereich auf der elektronischen Anordnung.

Ein weiterer Gegenstand der Erfindung ist eine (opto-)elektronische Anordnung umfassend zumindest eine (opto-)elektronische Struktur und eine Schicht der erfindungsgemäßen Barriereklebemasse , wobei die Klebemasseschicht die (opto-)elektronische Struktur vollflächig überdeckt.

Weitere Einzelheiten, Merkmale und Vorteile der vorliegenden Erfindung werden nachfolgend anhand bevorzugter Ausführungsbeispiele näher erläutert. In der Zeichnung zeigt

Abb. 5 eine (opto-)elektronische Anordnung nach dem Stand der Technik in schematischer Darstellung,

Abb. 6 eine erste erfindungsgemäße (opto-)elektronische Anordnung in schematischer Darstellung,

Abb. 7 eine zweite erfindungsgemäße (opto-)elektronische Anordnung in schematischer Darstellung.

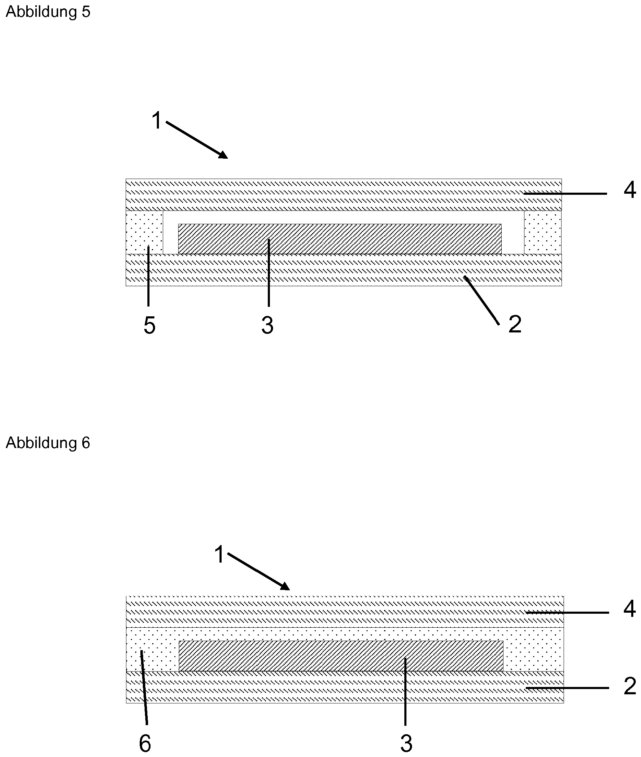

Abb. 5 zeigt eine erste Ausgestaltung einer organischen elektronischen Anordnung 1 nach dem Stand der Technik. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist ein Klebstoff 5 umlaufend neben der elektronischen Struktur 3 auf dem Substrat 2 vorgesehen. Dabei ist es unerheblich, ob der Klebstoff zunächst mit dem Substrat 2 verbunden wurde oder zuerst mit der Abdeckung 4. Der Klebstoff 5 verbindet die Abdeckung 4 mit dem Substrat 2. Durch eine entsprechend dicke Ausgestaltung ermöglicht der Klebstoff 5 zudem die Beabstandung der Abdeckung 4 von der elektronischen Struktur 3.

Bei dem Klebstoff 5 handelt es sich um eine solche nach dem Stand der Technik, also einen Klebstoff mit hoher Permeationsbarriere, der zudem zu einem hohen Anteil mit Gettermaterial gefüllt sein kann. Die Transparenz des Klebstoffs ist in diesem Aufbau nicht relevant.

Ein Transferklebeband würde vorliegend in Form eines Stanzlings bereitgestellt, welcher aufgrund seiner filigranen Geometrie schwieriger handzuhaben ist als ein im Wesentlichen vollflächig appliziertes Transferklebeband.

Abb. 6 zeigt eine erfindungsgemäße Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun der erfindungsgemäße Klebstoff, zum Beispiel in der Ausführung als Transferklebeband 6 vollflächig angeordnet. Die elektronische Struktur 3 wird somit von oben vollständig durch das Transferklebeband 6 gekapselt. Auf das Transferklebeband 6 ist sodann eine Abdeckung 4 aufgebracht. Bei dem Transferklebeband 6 handelt es sich um ein solches auf Basis des erfindungsgemäßen Transferklebebands wie es vorstehend in allgemeiner Form beschrieben wurde und nachfolgend in Ausführungsbeispielen näher dargelegt ist. Das Transferklebeband besteht in der dargestellten Ausführung nur aus einer Schicht eines erfindungsgemäßen Klebstoffs.

Die Abdeckung 4 muss im Gegensatz zu der vorherigen Ausgestaltung nicht zwingend die hohen Barriereanforderungen erfüllen, da bei vollflächiger Überdeckung der elektronischen Anordnung durch das Transferklebeband die Barriere bereits durch den Klebstoff bereitgestellt wird. Die Abdeckung 4 kann beispielsweise lediglich eine mechanische Schutzfunktion wahrnehmen, sie kann aber auch zusätzlich als Permeationsbarriere vorgesehen sein.

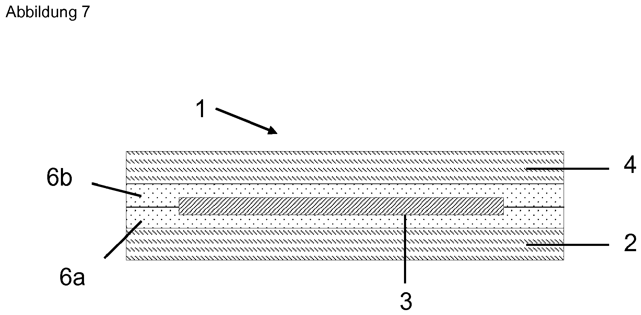

Abb. 7 zeigt eine alternative Ausgestaltung einer (opto-)elektronischen Anordnung 1. Im Gegensatz zu den vorherigen Ausgestaltungen sind nun zwei Transferklebebänder 6a, b vorgesehen, die vorliegend identisch ausgebildet sind, aber auch unterschiedlich sein können. Das erste Transferklebeband 6a ist vollflächig auf dem Substrat 2 angeordnet. Auf dem Transferklebeband 6a ist die elektronische Struktur 3 vorgesehen, die durch das Transferklebeband 6a fixiert wird. Der Verbund aus Transferklebeband 6a und elektronischer Struktur 3 wird dann mit dem weiteren Transferklebeband 6b vollflächig überdeckt, so dass die elektronische Struktur 3 von allen Seiten durch die Transferklebebänder 6a, b gekapselt ist. Oberhalb des Transferklebebands 6b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken. Insbesondere im Hinblick auf die Abb. 6 und 7 wird darauf hingewiesen, dass es sich vorliegend um schematische Darstellungen handelt. Aus den Darstellungen ist insbesondere nicht ersichtlich, dass das Transferklebeband hier und vorzugsweise jeweils eine homogene Schichtdicke aufweist. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum durchgeführt wird. Zudem wird die Klebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Auch ist ein direkter Kontakt des Klebstoffs mit dem elektronischen Aufbau nicht zwingend vorzusehen. Es können auch weitere Schichten dazwischen angeordnet sein wie zum Beispiel eine Dünnschichtverkapselung des elektronischen Aufbaus oder Barrierefilme.

Die Dicke des Transferklebebands kann alle üblichen Dicken umfassen, also etwa von 1 µm bis zu 3000 µm. Bevorzugt wird eine Dicke zwischen 25 und 100 µm, da in diesem Bereich Klebkraft und Handlingeigenschaften besonders positiv ausfallen. Ein weiterer bevorzugter Bereich ist eine Dicke von 3 bis 25 µm, da in diesem Bereich die Menge von durch die Klebefuge permeierenden Stoffen allein durch die kleine Querschnittsfläche der Klebefuge in einer Verkapselungsanwendung gering gehalten werden kann.

Zur Herstellung eines erfindungsgemäßen Transferklebebands wird der Träger des Klebebands oder der Liner einseitig mit dem erfindungsgemäßen Klebstoff aus Lösung oder Dispersion oder 100 %ig (zum Beispiel Schmelze) beschichtet oder bedruckt, oder das Klebeband wird durch (Co-)Extrusion hergestellt. Alternativ ist eine Herstellung durch Transfer einer erfindungsgemäßen Klebstoff-Schicht durch Kaschieren auf eine Trägermaterial oder einen Liner möglich. Die Klebestoffschicht kann durch Wärme oder energiereiche Strahlen vernetzt werden.

Bevorzugt findet dieser Herstellprozess in einer Umgebung statt, in der das spezifische Permeat nur in geringer Konzentration oder nahezu gar nicht enthalten ist. Als Beispiel kann eine relative Luftfeuchtigkeit von weniger als 30 %, bevorzugt von weniger als 15 % genannt werden.

### Beispiele

### Messmethoden

Die Messungen werden, sofern nichts anderes vermerkt ist, bei einem Prüfklima von 23 ± 1 °C und 50 ± 5 % rel. Luftfeuchte durchgeführt.

### Bestimmung der Durchbruchzeit (Lebensdauertest)

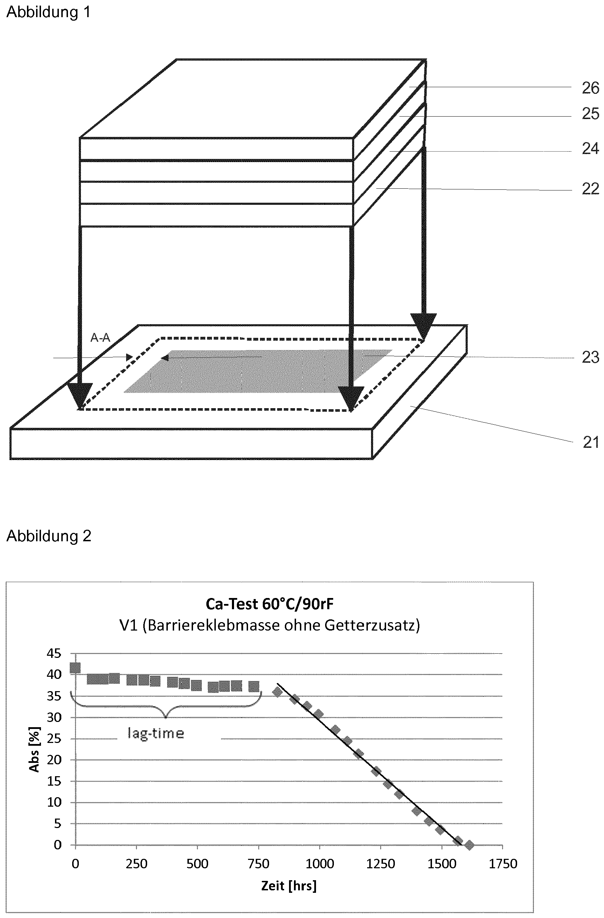

Als ein Maß für die Bestimmung der Lebensdauer eines elektronischen Aufbaus wurde ein Calciumtest herangezogen. Dieser ist in der Abbildung 1 gezeigt. Dazu wird im Vakuum eine 10 × 10 mm² große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (23 x 23 mm²) mit der zu testenden Klebemasse 22 sowie einer Dünnglasscheibe 24 (35 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 6,5 mm (A-A) abdeckt. Aufgrund des undurchlässigen Glasträgers 24 wird nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet. Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 60 °C und 90 % relative Luftfeuchte gewählt. Die Muster wurden mit einer Schichtdicke der Haftklebemasse von 50 µm vollflächig und blasenfrei verklebt. Der Abbau des Ca-Spiegels wird über Transmissionsmessungen verfolgt. Die Durchbruchzeit ist definiert als diejenige Zeit, die Feuchtigkeit benötigt, um die Strecke bis zum Ca zurückzulegen (vergleiche Abb.2). Bis zum Erreichen dieser Zeit ändert sich die Transmission des Ca-Spiegels nur wenig, danach steigt sie deutlich an.

### Permeabilität für Wasserdampf

Die Bestimmung der Permeabilität für Wasserdampf (WVTR) erfolgt nach ASTM F-1249. Die Haftklebemasse wird dazu mit einer Schichtdicke von 50 µm auf eine hochpermeable Polysulfon-Membran (erhältlich von der Firma Sartorius) aufgebracht, die selbst keinen Beitrag zur Permeationsbarriere liefert. Die Wasserdampfdurchlässigkeit wird bei 37,5 °C und einer relativen Feuchte von 90 % mit einem Messgerät Mocon OX-Tran 2/21 bestimmt.

### Molekulargewicht

Die Molekulargewichtsbestimmungen der zahlenmittleren Molekulargewichte Mₙ und der gewichtsmittleren Molekulargewichte M_{w} erfolgten mittels Gelpermeationschromatographie (GPC). Als Eluent wurde THF (Tetrahydrofuran) mit 0,1 Vol.-% Trifluoressigsäure eingesetzt. Die Messung erfolgte bei 25 °C. Als Vorsäule wurde PSS-SDV, 5 µ, 10³ Å, ID 8,0 mm x 50 mm verwendet. Zur Auftrennung wurden die Säulen PSS-SDV, 5 µ, 10³ sowie 10⁵ und 10⁶ mit jeweils ID 8,0 mm x 300 mm eingesetzt. Die Probenkonzentration betrug 4 g/l, die Durchflussmenge 1,0 ml pro Minute. Es wurde gegen Polystyrol-Standards gemessen.

### MMAP und DACP

MMAP ist der gemischte-Methylcyclohexan-Anilin-Trübungspunkt, der unter Verwendung eines modifizierten ASTM C 611-Verfahrens bestimmt wird. Methylcyclohexan ist für das in dem Standard-Prüfverfahren verwendete Heptan eingesetzt. Das Verfahren verwendet Harz/Anilin/Methylcyclohexan in einem Verhältnis von 1/2/1 (5 g/10 ml/5 ml) und der Trübungspunkt wird durch Abkühlen einer erhitzten, klaren Mischung der drei Komponenten, bis die vollständige Trübung gerade eintritt, bestimmt

Der DACP ist der Diaceton-Trübungspunkt und wird durch Abkühlen einer erhitzten Lösung von 5 g Harz, 5 g Xylol und 5 g Diacetonalkohol bis zu dem Punkt bestimmt, bei welchem die Lösung trübe wird.

### Ring & Ball-Erweichungstemperatur

Die Klebharzerweichungstemperatur wird nach der einschlägigen Methodik durchgeführt, die als Ring & Ball bekannt ist und nach ASTM E28 standardisiert ist.

Zur Bestimmung der Klebharzerweichungstemperatur der Harze kommt ein Ring-Kugel-Automat HRB 754 der Firma Herzog zum Einsatz. Harzmuster werden zunächst fein gemörsert. Das resultierende Pulver wird in einen Messingzylinder mit Bodenöffnung (Innendurchmesser am oberen Teil des Zylinders 20 mm, Durchmesser der Bodenöffnung des Zylinders 16 mm, Höhe des Zylinders 6 mm) gefüllt und auf einem Heiztisch geschmolzen. Die Befüllmenge wird so gewählt, dass das Harz nach dem Schmelzen den Zylinder ohne Überstand voll ausfüllt.

Der resultierende Probekörper wird samt Zylinder in die Probehalterung des HRB 754 eingelegt. Zur Befüllung des Temperierbads wird Glycerin verwendet, sofern die Klebharzerweichungstemperatur zwischen 50 °C und 150 °C liegt. Bei niedrigeren Klebharzerweichungstemperaturen kann auch mit einem Wasserbad gearbeitet werden. Die Prüfkugeln haben einen Durchmesser von 9,5 mm und wiegen 3,5 g. Entsprechend der HRB 754 Prozedur wird die Kugel oberhalb des Probekörpers im Temperierbad angeordnet und auf dem Probekörper abgelegt. 25 mm unter dem Zylinderboden befindet sich eine Auffangplatte, 2 mm über dieser eine Lichtschranke. Während des Messvorgangs wird die Temperatur mit 5 °C/min erhöht. Im Temperaturbereich der Klebharzerweichungstemperatur beginnt sich die Kugel durch die Bodenöffnung des Zylinders zu bewegen, bis sie schließlich auf der Auffangplatte zum Stehen kommt. In dieser Position wird sie von der Lichtschranke detektiert und zu diesem Zeitpunkt die Temperatur des Temperierbads registriert. Es findet eine Doppelbestimmung statt. Die Klebharzerweichungstemperatur ist der Mittelwert aus den beiden Einzelmessungen.

### Messung des Haze und der Transmission

Der HAZE-Wert beschreibt den Anteil des transmittierten Lichts, der von der durchstrahlten Probe nach vorne großwinklig gestreut wird. Somit quantifiziert der HAZE-Wert die opaken Eigenschaften einer Schicht, die die klare Durchsicht stören.

Die Transmission und der Haze des Klebstoffs wird analog ASTM D1003-11 (Procedure A (Hazemeter Byk Haze-gard Dual), Normlichtart D65) bei Raumtemperatur an einer 50 µm dicken Schicht des Klebstoffs bestimmt. Eine Korrektur von Grenzflächenreflextionsverlusten wird nicht vorgenommen.

Da bei dünnen Transferklebebändern die richtige Applikation am Messgerät wichtig ist, um das Messergebnis nicht zu verfälschen, wurde ein Hilfsträger verwendet. Als Träger wurde eine PC-Folie der Firma GE Plastics (Lexan 8010 Film, Dicke 125 µm) verwendet. Dieser Träger erfüllte alle Kriterien (glatte, plane Oberfläche, sehr geringer Haze-Wert, hohe Transmission, hohe Homogenität), um die Klebebandmuster plan am Messkanal anzubringen.

### Klebemassenschichten

Zur Herstellung von Klebemasseschichten wurden verschiedene Klebemassen aus einer Lösung auf einen konventionellen Liner (silikonisierte Polyesterfolie) mittels eines Laborstreichgeräts aufgebracht und getrocknet. Die Klebemassenschichtdicke nach dem Trocknen beträgt 50±5 µm. Die Trocknung erfolgte jeweils zunächst bei RT für 10 Minuten und 10 Minuten bei 120 °C in einem Labortrockenschrank. Die getrockneten Klebemasseschichten wurden jeweils unverzüglich nach dem Trocknen mit einem zweiten Liner (silikonisierte Polyesterfolie mit geringerer Trennkraft) auf der offenen Seite laminiert.

### Verwendete Rohstoffe:

| | |
|---|---|
| Sibstar 62M | SiBS (Polystyrol-block-Polyisobutylen-Blockcopolymer) der Firma Kaneka mit 20 Gew.-% Blockpolystyrolgehalt. Enthält zum Teil auch Diblockcopolymere. |
| | |
| Uvacure 1500 | cycloaliphatisches Diepoxid der Firma Cytec (3,4-Epoxycyclohexan) methyl 3,4-epoxycyclohexylcarboxylat) |
| HBE-100 | hydrierter Bisphenol A diglycidylether der Firma ECEM ein vollhydriertes Kohlenwasserstoffharz der Firma Exxon |
| Escorez 5300 | |
| Polyacrylat | (Ring and Ball 105 °C, DACP = 71, MMAP = 72) Acrylatcopolymer aus 2-Hydroxyethylacrylat, 2 Ethylhexylacrylat und C-17-Acrylat, Mₙ = 884000 g / mol |
| 2-(3,4-Epoxycyclohexyl)ethyltriethoxysilan | Triethoxysilan mit cycloaliphatischer Epoxidgruppe |
| Glycidoxypropyltriethoxysilan Vinyltrimethoxysilan | Triethoxysilan mit Glycidylepoxidgruppe |
| 2-(3,4-Epoxycyclohexyl)ethyl-trimethoxysilan | Trimethoxysilan mit cycloaliphatischer Epoxidgruppe |
| Incozol 2 | Wasserfänger der Firma Incorez (monocyclisches Alkyl-substituiertes Oxazolidin) |
| Octyltriethoxysilan | Triethoxysilan mit Octylgruppe (ohne reaktive Gruppe) kationischer Fotoinitiator von der Firma Sigma-Aldrich Der Photoinitiator weist ein Absorptionsmaximum im Bereich 320 nm bis 360 nm auf und lag als 50 Gew.-%-ige Lösung in Propylencarbonat vor |
| Triarylsulfoniumhexa-fluoroantimonat | |

### Das Polyacrylat wurde nach folgender Vorschrift hergestellt:

Ein für radikalische Polymerisationen konventioneller 2 L Glasreaktor wurde mit 40 g 2-Hydroxyethylacrylat, 240 g 2 Ethylhexylacrylat, 120 g C17-Acrylat (dreifach verzweigte Seiten mit C₃-, C₄-Kettensegmenten, BASF SE), 133 g Siedegrenzbenzin 69/95 und 133 g Aceton befüllt. Nachdem 45 Minuten Stickstoffgas unter Rühren durch die Reaktionslösung geleitet worden war, wurde der Reaktor auf 58 °C geheizt und 0,2 g Vazo 67 (Firma Du-Pont) hinzugegeben. Anschließend wurde das äußere Heizbad auf 75 °C erwärmt und die Reaktion konstant bei dieser Außentemperatur durchgeführt. Nach 1 h Reaktionszeit wurden 50 g Toluol hinzugegeben. Nach 2.5 h wurde mit 100 g Aceton verdünnt. Nach 4 h Reaktionszeit wurden nochmals 0,2 g Vazo 67 hinzugegeben. Nach 7 h Polymerisationszeit wurde mit 100 g Siedegrenzbenzin 60/95, nach 22 h mit 100 g Aceton verdünnt. Nach 24 h Reaktionszeit wurde die Polymerisation abgebrochen und das Reaktionsgefäß auf Raumtemperatur abgekühlt. Das Molekulargewicht Mₙ betrug 884000 g/mol.

Als Copolymer wurde ein Polystyrol-block-Polyisobutylen-Blockcopolymer der Firma Kaneka ausgewählt. Der Anteil an Styrol im Gesamtpolymer betrug 20 Gew.-%. Es wurde Sibstar 62M verwendet. Die Molmasse M_{w} beträgt 60.000 g/mol. Die Glasübergangstemperatur der Polystyrolblöcke betrug 100 °C und der Polyisobutylenblöcke -60 °C. Als Klebharz kam Escorez 5300 (Ring & Ball 105 °C, DACP = 71, MMAP = 72) der Firma Exxon, ein vollhydriertes Kohlenwasserstoffharz zum Einsatz. Als Reaktivharz wurde Uvacure 1500 der Firma Dow ausgewählt, ein cycloaliphatisches Diepoxid. Diese Rohstoffe sowie ggf. das Alkoxysilan wurden in einem Gemisch aus Toluol (300 g), Aceton (150 g) und Siedegrenzenbenzin 60/95 (550 g) gelöst, so dass eine 50 Gew.-% Lösung entsteht.

Anschließend wurde der Lösung ein Photoinitiator zugesetzt. Der Photoinitiator lag als 50 Gew.-%ige Lösung in Propylencarbonat vor. Der Photoinitiator weist ein Absorptionsmaximum im Bereich 320 nm bis 360 nm auf.

Die genaue Zusammensetzung der einzelnen Beispiele V1 bis V7 beziehungsweise K1 bis K3 ist der Tabelle 1 zu entnehmen.

**Tabelle 1:**

| **Beispiel:** | **K1** | **K2** | **K3** | **V1** | **V2** | **V3** | **V4** | **V5** | **V6** | **V7** | **V8** |
|---|---|---|---|---|---|---|---|---|---|---|---|
| | Gew.-Teile | Gew.-Teile | Gew.-Teile | Gew.-Teile | Gew.-Teile | Gew.-Teile | Gew.-Teile | Gew.-Teile | Gew.-Teile | Gew.-Teile | Gew.-Teile |
| Sibstar 62M | 37,5 | 37,5 | 20 | 37,5 | 37,5 | 37,5 | 37,5 | 22,5 | 37,5 | - | 37,5 |
| Uvacure 1500 | 20 | - | 55 | 25 | | 20 | 20 | 55 | 20 | - | 20 |
| HBE-100 | - | 20 | - | - | 25 | - | - | - | - | 20 | - |
| Escorez 5300 | 37,5 | 37,5 | 20 | 37,5 | 37,5 | 37,5 | 37,5 | 22,5 | 37,5 | | 37,5 |
| Polyacrylat | - | - | | - | - | - | - | | - | 75 | - |
| 2-(3,4-Epoxycyclohexyl)ethyltriethoxysilan | 5 | - | 5 | - | - | - | - | - | - | - | - |
| Glycidoxy-propyltri-ethoxysilan | - | 5 | - | | | - | - | - | - | 5 | - |
| Vinyltri-methoxysilan | - | - | - | - | - | 5 | - | - | - | | - |
| 2-(3,4-Epoxycyclohexyl)ethyl-trimethoxysilan | - | - | - | - | - | - | 5 | - | - | | - |
| Incozol 2 | | | | | | | | | 5 | | |
| Octyltri-ethoxysilan | | | | | | | | | | | 5 |
| Triarylsulfonium-hexafluoroantimonat | 0,1 | 0,1 | 0,1 | 0,1 | 0,1 | 0,1 | 0,1 | 0,1 | 0,1 | 0,1 | 0,1 |

Die Muster wurden in eine Glove-Box eingeschleust. Ein Teil der Muster wurde auf einem mit Ca bedampften Glassubstrat mit einem Gummianroller blasenfrei laminiert. Darauf wurde der zweite PET-Liner ausgedeckt und eine Lage eines Dünnglases auflaminiert. Anschließend wurde durch das Abdeckglas mittels UV-Licht gehärtet (Dosis: 80 mJ/cm²; Lampentyp: undotierter Quecksilberstrahler). Dieses Muster wurde für den Lebensdauertest verwendet.

Die Ergebnisse der Feuchtigkeitspermeationsmessung der Basismassen (V1/V2/V5) und einer Acrylatmasse (V7) ohne Zugabe eines Wasserfängers sind in Tabelle 2 wiedergegeben.

**Tabelle 2:**

| | **V1** | **V2** | **V5** | **V7** |
|---|---|---|---|---|
| **WVTR / g m⁻²d⁻¹** | 7 | 6 | 22 | 673 |

Dies zeigt, dass alle hier beschriebenen Massen außer V7 sehr niedrige WVTR-Werte (kleiner 100 g/m²d, bevorzugt weniger als 50 g/m²d insbesondere weniger als 15 g/m²d) haben. Vergleicht man diese Ergebnisse mit den erzielten Barriereeigenschaften, so ist festzustellen, dass lediglich die erfindungsmäßigen Massen mit weniger als 100 g/m²d eine Durchbruchzeit (lag-time) aufweisen.

Die ermittelten Durchbruchzeiten von Wasser im Ca-Test sind in der folgenden Tabelle 3 aufgeführt:

**Tabelle 3:**

| **Bezeichnung** | **K1** | **K2** | **K3** | **V1** | **V2** | **V3** | **V4** | **V5** | **V6** | **V7** | **V8** |
|---|---|---|---|---|---|---|---|---|---|---|---|
| **lag-time 60°C / 90% r.F.** | 1300 | 920 | 1500 | 750 | 500 | 800 | 1150 | 1250 | 0 | 0 | 1100 |
| **lag-time 85°C / 85% r.F.** | 240 | 150 | 300 | 155 | 105 | 150 | 200 | 270 | 0 | 0 | 190 |

Zunächst zeigt der Vergleich von K1 und V8, dass eine aktivierbare Gruppe am Silan vorteilhaft ist. Des Weiteren zeigt der Vergleich von V3 und V4, dass es überraschenderweise vorteilhaft ist, nicht nur irgendeine einpolymerisierbare Gruppe im Silan mitanzubieten, sondern dass eine zu der des Reaktivharzes vergleichbare Gruppe vorteilhaft ist. Dies ist für den Fachmann nicht zu erwarten, da beide Gruppen, sowohl die Vinyl- (V3), als auch die Cyclohexylepoxidgruppe (V4) in der kationischen Polymerisation miteingebunden werden. So sind die beiden Zusammensetzungen der beiden Vergleichsbeispiele nahezu identisch. V3 hat jedoch im Gegensatz zu V4 einen Silangetter, der Vinylgruppen für die kationische Polymerisation bereitstellt. Es zeigt sich (Tabelle 3), dass die lag-time für das Silan mit den gleichartigen reaktiven Gruppen wie die des Reaktivharzes (in diesem Fall 2,3 Epoxycyclohexyl des Beispiels V4) eine signifikant höhere lag-time aufweist.

Darüber hinaus zeigen die Beispiele und Vergleichsbeispiele, dass überraschenderweise das unreaktivere Triethoxysilan sowohl bei 60 °C / 90 % r.F. als auch vor allen Dingen bei 85 °C / 85 % r.F. deutlich vorteilhaft gegenüber den reaktiveren Vinyl- und Epoxycyclohexyl-Trimethoxysilan ist.

Auch für nicht haftklebrige Flüssigkleber (K3) lässt sich eine deutlich verbesserte Durchbruchzeit mit dem entsprechenden Epoxycyclohexyl-Getter erzielen (Vergleich K3/V5).

### Kompatibilität der Klebmassen mit OLEDs und Kathodenmaterial (Calcium)

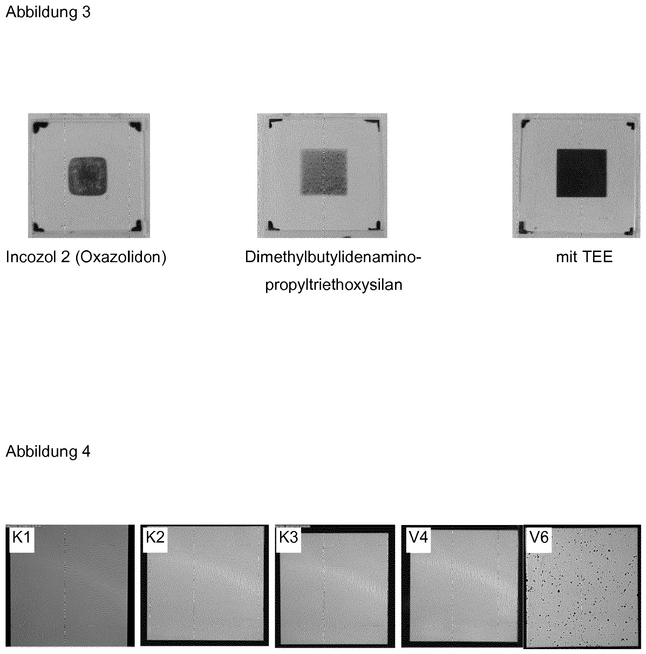

Bekannte transparente Getter wurden in eine Klebmasse zu 5 Gew.-% eingearbeitet. Die Reaktivität dieser Wasserfänger ist so groß, dass bereits im Ca-Test die Calciumfläche angegriffen wurde. Verwendet man TEE, bleibt das Calcium unberührt. Dies ist fotografisch in Abb. 3 festgehalten.

Die OLED-Kompatibilität konnte für die einpolymerisierbaren Alkoxysilane nachgewiesen werden, indem solche Klebmassen auf unverkapselte polymere OLEDs verklebt wurden und 150 h bei 60 °C / 90 % r.F. gelagert wurden. Als Gegenbeispiel zeigte ein Standard organischer Wasserfänger (Incozol, V6) deutliche Schädigungen (dark-spots). Die Ergebnisse sind in Abbildung 4 wiedergegeben.

Tabelle 4 fasst die Beobachtungen noch einmal zusammen.

**Tabelle 4:**

| **Verklebung auf** | **K1** | **K2** | **K3** | **V4** | **V6** | **V1 + 5% DBAPTS*** |
|---|---|---|---|---|---|---|
| Calcium | keine Schädigung | keine Schädigung | keine Schädigung | keine Schädigung | starke Schädigung | starke Schädigung |
| OLED Kathode (Barium-Aluminium) | keine Schädigung | keine Schädigung | keine Schädigung | keine Schädigung | viele dark-spots | viele dark-spots |

| | | | | | | |
|---|---|---|---|---|---|---|
| * DBAPTS: Dimethylbutylidenamino propyltriethoxysilan | | | | | | |

## Patentansprüche

1. Barriereklebemasse, enthaltend
eine Klebstoffbasis aus
- mindestens einem Reaktivharz mit mindestens einer aktivierbaren Gruppe
- mindestens einem Elastomer
- optional mindestens einem Klebharz,
wobei die Klebstoffbasis eine Wasserdampfpermeationsrate nach der Aktivierung des Reaktivharzes von weniger als 100 g/m²d, bevorzugt von weniger als 50 g/m²d, insbesondere weniger als 15 g/m²d aufweist, bestimmt gemäß der Messmethode "Permeabilität für Wasserdampf" wie im Messmethodenteil der Beschreibung angegeben,
ein transparentes molekular dispergiertes Gettermaterial sowie optional ein Lösungsmittel,
**dadurch gekennzeichnet, dass**
das Gettermaterial mindestens ein Silan ist, das mindestens eine Alkoxygruppe und mindestens eine aktivierbare Gruppe aufweist, wobei das Reaktivharz und das Silan chemisch gleichartige aktivierbare Gruppen aufweisen,
die aktivierbare Gruppe mindestens eine Gruppe ausgewählt aus der Gruppe, umfassend cyclische Ethergruppen, insbesondere Epoxide und Oxetane, Acrylate und Methacrylate, ist,
die Klebemasse haftklebrig ist und
das Elastomer mindestens ein Vinylaromatenblockcopolymer ist.

2. Barriereklebemasse, nach Anspruch 1, **dadurch gekennzeichnet, dass** Reaktivharz und Silan dieselben aktivierbaren Gruppen aufweisen.

3. Barriereklebemasse nach Anspruch 1 oder 2, **dadurch gekennzeichnet, dass** die Alkoxygruppe eine Ethoxygruppe ist.

4. Barriereklebemasse nach zumindest einem der Ansprüche 1 bis 3, **dadurch gekennzeichnet, dass** die Menge an Gettermaterial mindestens 2 Gew.-%, vorzugsweise mindestens 3 Gew.-%, insbesondere mindestens 5 Gew.-% der Klebemasse beträgt.

5. Barriereklebemasse nach zumindest einem der vorherigen Ansprüche, **dadurch gekennzeichnet, dass** die Menge an Gettermaterial höchstens 15 Gew.-% beträgt.

6. Barriereklebemasse nach zumindest einem der vorherigen Ansprüche, **dadurch gekennzeichnet, dass** die Menge an Gettermaterial 3 bis 15 Gew.-%, vorzugsweise 4 bis 10 Gew.-% und insbesondere 4,5 bis 7 Gew.-% beträgt.

7. Barriereklebemasse nach zumindest einem der vorherigen Ansprüche, **dadurch gekennzeichnet, dass** das mindestens eine Reaktivharz als aktivierbare Gruppen mindestens eine Gruppe, ausgewählt aus Glycidyl- und Epoxycyclohexylgruppe, enthält.

8. Barriereklebemasse nach zumindest einem der vorherigen Ansprüche, **dadurch gekennzeichnet, dass** das mindestens eine Silan eine Verbindung der allgemeinen Formel 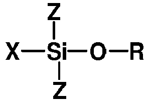
ist, wobei R ein Alkyl- oder ein Arylrest ist, wobei Ethyl besonders bevorzugt ist;
wobei X ein Rest mit Glycidyl- oder Epoxycyclohexylgruppe, ein Acrylat oder ein Methacrylat ist,;
und Z eine Alkyl- oder Arylgruppe oder eine Alkoxygruppe ist,
wobei die Reste Z gleich oder verschieden sein können.

9. Barriereklebemasse nach Anspruch 8, **dadurch gekennzeichnet, dass** mindestens ein Rest Z eine Ethoxygruppe ist.

10. Barriereklebemasse nach zumindest einem der vorherigen Ansprüche, **dadurch gekennzeichnet, dass** sie kationisch, und zwar bevorzugt thermisch oder strahleninduziert, ausgehärtet wird.

11. Barriereklebemasse nach zumindest einem der vorherigen Ansprüche, **dadurch gekennzeichnet, dass** sie des Weiteren einen Photoinitiator enthält.

12. Klebeband enthaltend eine Barriereklebemasse nach einem der Ansprüche 1 bis 11.

13. Verwendung der Barriereklebemasse nach zumindest einem der Ansprüche 1 bis 11 oder des Klebebandes nach Anspruch 12 zur Verkapselung von Aufbauten in der organischen Elektronik.

14. Verfahren zum Schutz einer auf einem Substrat angeordneten organischen elektronischen Anordnung,
wobei eine Abdeckung derart auf die elektronische Anordnung aufgebracht wird, dass die elektronische Anordnung zumindest teilweise durch die Abdeckung überdeckt wird,
wobei weiterhin die Abdeckung zumindest teilflächig auf dem Substrat und/oder auf der elektronischen Anordnung verklebt wird,
wobei die Verklebung mittels zumindest einer Schicht einer Barriereklebemasse nach zumindest einem der Ansprüche 1 bis 11 bewirkt wird.

15. Verfahren nach Anspruch 14,
**dadurch gekennzeichnet, dass**
die Barriereklebemasse als Schicht eines Klebebands vorliegt.

16. Verfahren nach zumindest einem der Ansprüche 14 oder 15,
**dadurch gekennzeichnet, dass**
zunächst die Schicht der Barriereklebemasse, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird.

17. Verfahren nach zumindest einem der Ansprüche 14 oder 15,
**dadurch gekennzeichnet, dass**
die Schicht der Barriereklebemasse und die Abdeckung gemeinsam auf das Substrat und/oder die elektronische Anordnung aufgebracht werden.

18. Verfahren nach zumindest einem der Ansprüche 14 bis 17,
**dadurch gekennzeichnet, dass**
die Abdeckung die elektronische Anordnung vollständig überdeckt.

19. Verfahren nach zumindest einem der Ansprüche 14 bis 18,
**dadurch gekennzeichnet, dass**
auch ein Bereich des Substrats um die elektronische Anordnung herum durch die Abdeckung ganz oder teilweise überdeckt wird.

## Claims

1. Barrier adhesive comprising
an adhesive base composed of
- at least one reactive resin having at least one activatable group,
- at least one elastomer,
- optionally at least one tackifying resin,
where the adhesive base has a water vapour permeation rate after the activation of the reactive resin of less than 100 g/m²d, preferably of less than 50 g/m²d, especially less than 15 g/m²d, determined according to the "Permeability to water vapour" test method as specified in the test methods section of the description,
a transparent molecularly dispersed getter material and
optionally a solvent,
**characterized in that**
the getter material is at least one silane having at least one alkoxy group and at least one activatable group, where the reactive resin and silane have chemically the same kind of activatable groups,
the activatable group is at least one group selected from the group comprising cyclic ether groups, especially epoxides and oxetanes, acrylates and methacrylates,
the adhesive is a pressure-sensitive adhesive and the elastomer is at least one vinylaromatic block copolymer.

2. Barrier adhesive according to Claim 1, **characterized in that** reactive resin and silane have the same activatable groups.

3. Barrier adhesive according to Claim 1 or 2, **characterized in that** the alkoxy group is an ethoxy group.

4. Barrier adhesive according to at least one of Claims 1 to 3, **characterized in that** the amount of getter material is at least 2% by weight, preferably at least 3% by weight and especially at least 5% by weight of the adhesive.

5. Barrier adhesive according to at least one of the preceding claims, **characterized in that** the amount of getter material is not more than 15% by weight.

6. Barrier adhesive according to at least one of the preceding claims, **characterized in that** the amount of getter material is 3% to 15% by weight, preferably 4% to 10% by weight and especially 4.5% to 7% by weight.

7. Barrier adhesive according to at least one of the preceding claims, **characterized in that** the at least one reactive resin comprises, as activatable groups, at least one group selected from glycidyl and epoxycyclohexyl group.

8. Barrier adhesive according to at least one of the preceding claims, **characterized in that** the at least one silane is a compound of the general formula 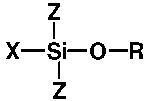 where R is an alkyl or aryl radical, particular preference being given to ethyl;
where X is a radical having a glycidyl or epoxycyclohexyl group, an acrylate or a methacrylate; and Z is an alkyl or aryl group or an alkoxy group, where the Z radicals may be the same or different.

9. Barrier adhesive according to Claim 8, **characterized in that** at least one Z radical is an ethoxy group.

10. Barrier adhesive according to at least one of the preceding claims, **characterized in that** it is cured by cationic means, and preferably by thermal or radiation-induced means.

11. Barrier adhesive according to at least one of the preceding claims, **characterized in that** it further comprises a photoinitiator.

12. Adhesive tape comprising a barrier adhesive according to any of Claims 1 to 11.

13. Use of the barrier adhesive according to at least one of Claims 1 to 11 or of the adhesive tape according to Claim 12 for encapsulation of assemblies in organic electronics.

14. Method for protecting an organic electronic arrangement disposed on a substrate,
wherein a cover is applied to the electronic arrangement in such a way that the electronic arrangement is at least partly covered by the cover, wherein the cover is additionally bonded over at least part of the area on the substrate and/or on the electronic arrangement,
wherein the bonding is brought about by means of at least one layer of a barrier adhesive according to at least one of Claims 1 to 11.

15. Method according to Claim 14,
**characterized in that**
the barrier adhesive takes the form of a layer of an adhesive tape.

16. Method according to at least one of Claims 14 and 15, **characterized in that**
the layer of the barrier adhesive, optionally as a constituent of a double-sided adhesive tape comprising further layers, is applied first, and in a subsequent step the cover is applied to the substrate and/or the electronic arrangement.

17. Method according to at least one of Claims 14 and 15, **characterized in that**
the layer of the barrier adhesive and the cover are applied together to the substrate and/or the electronic arrangement.

18. Method according to at least one of Claims 14 to 17, **characterized in that**
the cover fully covers the electronic arrangement.

19. Method according to at least one of Claims 14 to 18, **characterized in that**
a region of the substrate around the electronic arrangement is also wholly or partly covered by the cover.

## Revendications

1. Matière adhésive formant barrière, contenant une base d'adhésif constituée
- d'au moins une résine réactive comportant au moins un groupe activable,
- d'au moins un élastomère,
- en option d'au moins une résine adhésive,
la base d'adhésif présentant un taux de perméabilité à la vapeur d'eau après l'activation de la résine réactive de moins de 100 g/m²d, de préférence de moins de 50 g/m²d, en particulier moins de 15 g/m²d, déterminé conformément à la méthode de mesure « Perméabilité à la vapeur d'eau » telle qu'indiquée dans la partie Méthodes de mesure de la description,
une matière de sorption transparente en dispersion moléculaire ainsi
qu'en option d'un solvant,
**caractérisée en ce que**
la matière de sorption est au moins un silane qui comporte au moins un groupe alcoxy et au moins un groupe activable, la résine réactive et le silane comportant des groupes activables chimiquement de même nature,
le groupe activable est au moins un groupe choisi dans le groupe comprenant les groupes éther cyclique, en particulier époxydes et oxétanes, les acrylates et méthacrylates
la matière adhésive est autoadhésive et
l'élastomère est au moins un copolymère à blocs de composés vinylaromatiques.

2. Matière adhésive formant barrière selon la revendication 1, **caractérisée en ce que** résine réactive et silane comportent les mêmes groupes activables.

3. Matière adhésive formant barrière selon la revendication 1 ou 2, **caractérisée en ce que** le groupe alcoxy est un groupe éthoxy.

4. Matière adhésive formant barrière selon au moins l'une des revendications 1 à 3, **caractérisée en ce que** la quantité de matière de sorption représente au moins 2 % en poids, de préférence au moins 3 % en poids, en particulier au moins 5 % en poids de la matière adhésive.

5. Matière adhésive formant barrière selon au moins l'une des revendications précédentes, **caractérisée en ce que** la quantité de matière de sorption représente au maximum 15 % en poids.

6. Matière adhésive formant barrière selon au moins l'une des revendications précédentes, **caractérisée en ce que** la quantité de matière de sorption représente 3 à 15 % en poids, de préférence 4 à 10 % en poids et en particulier 4,5 à 7 % en poids.

7. Matière adhésive formant barrière selon au moins l'une des revendications précédentes, **caractérisée en ce que** ladite au moins une résine réactive contient en tant que groupes activables au moins un groupe choisi parmi le groupe glycidyle et le groupe époxycyclohexyle.

8. Matière adhésive formant barrière selon au moins l'une des revendications précédentes, **caractérisée en ce que** ledit au moins un silane est un composé de formule générale 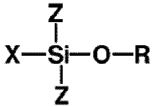
R étant un radical alkyle ou un radical aryle, éthyle étant particulièrement préféré ;
X étant un radical à groupe glycidyle ou époxycyclohexyle, un acrylate ou un méthacrylate ;
et Z étant un groupe alkyle ou aryle ou un groupe alcoxy,
les radicaux Z pouvant être identiques ou différents.

9. Matière adhésive formant barrière selon la revendication 8, **caractérisée en ce que** ledit au moins un radical Z est un groupe éthoxy.

10. Matière adhésive formant barrière selon au moins l'une des revendications précédentes, **caractérisée en ce qu'**elle est durcie par voie cationique, et en réalité de préférence thermiquement ou par induction par irradiation.

11. Matière adhésive formant barrière selon au moins l'une des revendications précédentes, **caractérisée en ce qu'**elle contient en outre un photoamorceur.

12. Ruban adhésif contenant une matière adhésive formant barrière selon l'une quelconque des revendications 1 à 11.

13. Utilisation de la matière adhésive formant barrière selon au moins l'une des revendications 1 à 11 ou du ruban adhésif selon la revendication 12 pour l'encapsulation de structures dans l'électronique organique.

14. Procédé pour la protection d'un dispositif électronique organique disposé sur un substrat,
dans lequel une couverture est appliquée sur le dispositif électronique de telle façon que le dispositif électronique soit recouvert au moins partiellement par la couverture,
dans lequel en outre la couverture est collée au moins sur une surface partielle sur le substrat et/ou sur le dispositif électronique,
dans lequel le collage est réalisé au moyen d'au moins une couche d'une matière adhésive formant barrière selon au moins l'une des revendications 1 à 11.

15. Procédé selon la revendication 14,
**caractérisé en ce que**
la matière adhésive formant barrière est présente en tant que couche d'un ruban adhésif.

16. Procédé selon au moins l'une des revendications 14 et 15,
**caractérisé en ce que**
d'abord la couche de la matière adhésive formant barrière, éventuellement en tant que composant d'un ruban adhésif collant double face comprenant d'autres couches, et dans une étape subséquente, la couverture, sont appliquées sur le substrat et/ou le dispositif électronique

17. Procédé selon au moins l'une des revendications 14 et 15,
**caractérisé en ce que**
la couche de la matière adhésive formant barrière et la couverture sont appliquées ensemble sur le substrat et/ou le dispositif électronique.

18. Procédé selon au moins l'une des revendications 14 à 17,
**caractérisé en ce que**
la couverture recouvre en totalité le dispositif électronique.

19. Procédé selon au moins l'une des revendications 14 à 18,
**caractérisé en ce**
**qu'**une zone du substrat autour du dispositif électronique est également recouverte en partie ou en totalité par la couverture.
